# EUROPEAN PATENT SPECIFICATION

(11) **EP 2 963 145 B1**
(45) Date of publication and mention of the grant of the patent: **31.01.2018**
(21) Application number: 15171849.1
(22) Date of filing: 12.06.2015
(51) Int. Cl.: C23C 14/06, C23C 14/35, C23C 14/32, C23C 14/02, C10M 103/04, C23C 14/16, C23C 14/34, H01J 37/34

(54) **COATING AND METHOD FOR ITS DEPOSITION TO OPERATE IN BOUNDARY LUBRICATION CONDITIONS AND AT ELEVATED TEMPERATURES**
BESCHICHTUNG UND VERFAHREN ZU IHRER ABSCHEIDUNG ZUM BETRIEB UNTER GRENZFLÄCHENSCHMIERUNGS-BEDINGUNGEN UND BEI ERHÖHTER TEMPERATUR
REVÊTEMENT ET PROCÉDÉ DE SON DÉPÔT POUR L'UTILISATION AUX CONDITIONS DE LUBRICATION INTERFACIELLES ET À TEMPÉRATURE AUGMENTÉE

(30) Priority: 30.06.2014 EP 14175063
(43) Date of publication of application: 06.01.2016
(73) Proprietor: IHI Hauzer Techno Coating B.V., 5928 LL Venlo (NL)
(72) Inventor: HOVSEPIAN, Papken E., Sheffield, S2 5LZ (GB); DOERWALD, Dave, 8515 HP Nijmegen (NL); TIETEMA, Roel, 5926 SK Venlo (NL); EHIASARIAN, Arutiun Papken, Sheffield S11 9RB (GB)
(74) Representative: Manitz Finsterwald Patentanwälte PartmbB

(56) References cited:
- EP-A1- 2 568 059
- EP-A1- 2 628 817
- WO-A1-96/41034
- WO-A1-2007/020138
- WO-A1-2015/150481
- DE-A1-102012 007 796
- US-A1- 2009 065 350

## Description

The present invention relates to a coating and to methods for its deposition, the coating being intended to operate in boundary lubrication conditions and at elevated temperatures.

Dynamic lubrication is frequently used in industry, in machines and in motor cars for the lubrication between two relatively moving components. One example is the oil film that is present between a shell bearing and a crankshaft. The idea is to maintain an oil film between the two components so that the two relatively moving surfaces are not in physical contact. If physical contact occurs then the surfaces wear rapidly and mechanical damage or failure results. Sometimes the lubrication is inadequate so that asperities on the surface of one component rub on asperities of the other component, which may not be catastrophic but nevertheless leads to unwanted wear and reduced working life. Such situations can be summarised under the term "boundary lubrication"

One prime example of boundary lubrication is the lubrication of piston rings which scrape over the running surface of a cylinder. In that example there is supposed to be thin film of lubricant separating the piston ring from the cylinder wall and indeed facilitating movement of the piston ring in the piston ring groove. However, in modern engines which use relatively little oil the lubrication of the piston rings is critical and can certainly be classed as a boundary lubrication condition. Even with adequate oil supply boundary lubrication conditions can arise elsewhere in a motor vehicle engine or in machinery generally. In a motor car engine such boundary lubrication can for example arise between crankshafts and shell bearings, between camshafts and camshaft followers or between rocker arms and valve actuation mechanisms as well as in fuel injection systems to name but a few examples. Thus in boundary lubrication the ideal situation of no real contact between rubbing partners is not met and contact can occur. The problem becomes worse as operating temperatures rise. For example piston ring temperatures up to 250° C or even 350°C can arise and as circulating oil is often at temperatures above 100°C corresponding component temperatures, e.g. in the area of the crankshaft and the valve train/cam train, are frequent.

Various, generally relatively hard, coatings have been devised in order to improve the situation with regard to boundary lubrication conditions at elevated temperatures. Such coatings are frequently deposited by PACVD or PAPVD techniques. One know form of coating is a so-called DLC coating which is an abbreviation for a diamond like carbon coating which contains predominantly sp3 carbon bonds and has a structure resembling diamond. The coating, which can be regarded as a benchmark coating for piston rings, is almost as hard as diamond. It is typically applied in a plasma assisted reactive chemical deposition process referred to as PACVD or PECVD. However this is relatively costly as the deposition rate is relatively slow. Furthermore DLC coatings suffer from poor adhesion due to their high stress and inefficient surface treatment prior to the coating deposition.

DE 10 2012 007 796 A is related to metal (Me) doped DLC coated sliding members, such as piston rings. Me may be Ti, V, Cr, Zr, Nb, Mo, Hf, Ta, Ni, W. W-doped DLC is disclosed as preferred embodiment. The mean Me content is most preferably 5 to 20 at.%. The principal object underlying the present invention is to provide a novel coating which can be applied cost effectively by PVD processes, which is entirely competitive with existing DLC coatings and indeed potentially superior especially at elevated temperatures under boundary lubrication conditions.

In order to satisfy this object there is provided a metal doped carbon coating as specified in claim 1, wherein the Me-doped C coating is for operation in boundary lubrication conditions, in which the metal is present in the coating in an amount of from 5 to 20% by atomic percent and the ratio of the atomic percentage of the metal Me to the atomic percentage of the carbon C does not exceed 1:4, the metal being capable of forming a metal sulphide with sulphur present in a lubricant and being a mixture of Wand Mo in a ratio in the range by atomic percent of W:Mo from 0.5:1 to 4:1.

It has surprisingly been found that a coating of this kind is capable of providing low friction and low wear of the coated component and its running partner even under boundary lubrication conditions and at elevated temperatures. It has been surprisingly found that the claimed Me-doped carbon coating does not suffer from oxidation damage in dry air up to 500°C and outperform DLC coatings in lubricated sliding at elevated temperatures as high as 200°C. Metal DLC coatings are admittedly known per se but have always been considered inferior to DLC coatings. The applicants have found, to their surprise, that metal DLC coatings with the special percentage of 5 to 20 atomic percent of a mixture of Mo and W have enhanced efficiency in boundary lubrication conditions. Metal contents in an amount above 20% by atomic percent are significantly poorer in performance than coatings with less than or equal to 20% by atomic percent. If the metal content is reduced below 5 atomic percent there seems to be insufficient metal in the coating for the beneficial effect to occur and endure over a long operating period. Generally the preferred proportion of the metal in atomic percent is in the range from 10 to 20%, with proportions near to 20% being especially preferred.

Both Mo and W are metals capable of forming a metal sulphide with sulphur present in a lubricant. The applicants have evidence that conclusively shows that such metals do indeed react with the sulphur in the lubricant to form the metal sulphide and metal sulphides are known to be good solid lubricants per se.

Fortuitously sulphur seems to be present in almost all lubricants used in internal combustion engines or other machinery. The sulphur seems to be present in a compound with hydrogen or hydrocarbons in basic oil as obtained in refineries or in synthetic oils without special additives having been added, They are therefore also present in so-called formulated oils to which a variety of additives have been added. Some oils already contain MoS₂ as an additive, however the coating proposed herein has an effect cumulative to the presence of such additives. Moreover, there is a highly significant difference in that, in the present invention, the metal sulphide is not added to the lubricant as a compound but is generated precisely at the point it is needed (at the metal to metal contact areas) and indeed repeatedly during the operation of the engine or the machine. Moreover, the process of metal sulphide formation is enhanced at higher temperatures, such as those prevailing in internal combustion engines and at the surfaces of piston rings. Particularly beneficial results are achieved when the mixture of W and Mo in a ratio in the range by atomic percent of W:Mo from 0.5:1 to 4:1 preferably from 1:1 to 3:1 and especially of about 2:1. With such metal mixtures, the performance of the coating at room temperature is comparable to that of pure DLC and is considerably better at elevated temperature, such as occur at piston ring surfaces.

This is particularly surprising since DLC films contain generally upwards of 90% sp3 bonds whereas the present coating typically has a ratio of sp2 carbon bonds to sp3 carbon bonds is in the range from sp2/sp3 equal to 20 to 50% preferably 30 to 35%. This also tends to produce smoother surfaces than DLC coatings which can be a significant advantage. Roughness values for the coatings of the present invention are found to lie in the range from Ra= 0.01 µm to Ra=0.07 µm. Standard pin on disc tests have shown that under lubricated conditions the coating proposed here is equivalent in performance to a DLC coating but becomes superior as the operating temperature is increased.

As mentioned above the metal doped hard carbon coatings proposed here can operate at least at a temperature in the range from 0°C-500°C and have their best properties at higher temperatures above 150°C.

The typical range of useful thickness of the coatings proposed here is from 500nm to 10µm and the typical hardness is in the range from12 GPa to20 GPa.

A method for depositing the metal doped hard carbon coating of the invention on a workpiece comprises the following method steps:
A) pre-treating a workpiece surface by simultaneous bombardment of the surface with accelerated ions of at least one of W and C ions, Mo and C ions and W, Mo and C ions generated by a HIPIMS discharge in a treatment chamber,
B) deposition of a transition layer of metal and/or metal nitride of a thickness in the range from 20nm-1000nm thick by magnetron sputtering, the metal being at least one of W and Mo,
C) deposition of a main layer comprising the Me- doped C coating by magnetron sputtering using one of the following cathode configurations:
   a) a HIPIMS sputtering cathode comprising W, Mo and C and being either a cathode made from the respective components W, Mo and C, or of WC and Mo made by a powder metallurgical sintering route, or by casting or by mechanical segmentation and an associated HIPIMS power supply,
   b) a HIPIMS sputtering cathode comprising W and Mo, and an associated HIPIMS power supply,
   c) a first HIPIMS sputtering cathode comprising one of Wand WC and a second HIPIMS sputtering cathode comprising Mo, each cathode having an associated HIPIMS power supply, which may be a common power supply,
   d) any one of the foregoing cathode configurations a), b) and c) in combination with one or more graphite cathodes each with an associated DC sputtering power supply, which may be a common power supply.

This method is particularly advantageous for a variety of reasons. First of all it is basically a non-reactive sputtering process which does not involve any reactive gas, unless nitrogen is admitted to the vacuum chamber during the method step B) for the formation of a metal nitride transition layer, which is by no means essential but an option. Magnetron sputtering is known to produce droplet free smooth layers, particularly when HIPIMS is used for sputtering. The deposition of the carbon in the coating can be done simply by having enough carbon in a single composite cathode of WC and C, for example in the form of a segmented cathode or one made by powder metallurgy, or enough carbon in a single composite cathode of W and/or WC with Mo and C, for example again in the form of a segmented cathode or one made by powder metallurgy. It is however generally more convenient to provide at least one additional graphite cathode that is operated in addition to cathode configurations a), b) or c) in a DC sputtering mode. Typically separate graphite cathodes with an area about three times as great as the area of the cathode(s) of configurations a), b) or c) is used. This reflects the circumstance that graphite targets for magnetron sputtering have to be operated at power densities significantly lower than the power density which can be applied to a metallic cathode operated in a HIPIMS mode and the sputtering yields are different.

For example, three graphite cathodes each of 1200 square cm's area can be operated in a DC sputtering mode at 5 to 6KW of applied power. The single target of WC and Mo with an area of 1200 square cm is also operated in a HIPIMS mode at an average power of 5 to 6 kW. If desired it could be operated at a higher average power. The important thing is to achieve the correct proportion of metal in the coating by atomic percent. The operation of the DC sputtering from the graphite cathodes at the same time as the HIPIMS sputtering from the cathode configurations a), b) and c) results in the desired ratio of metal to carbon of 20% or somewhat less having regard to the sputtering yields from graphite, tungsten, tungsten carbide and molybdenum cathodes.

Moreover, the operation of the cathode configurations a), b) and c) in a HIPIMS mode has a particularly beneficial effect on the DC sputtering from the graphite cathodes. This namely results in the desired ratio of sp2 to sp3 bonds in the hard carbon coating. Since the Me and hard carbon coating is deposited in one step the process is very efficient and the production rate is relatively high compared to that of DLC coatings, about twice as high, which is another significant advantage. The metal used for the adhesive layer can also be produced from the cathodes of the configurations a), b) or c) with the DC magnetrons from the graphite cathodes being inoperative during the method step B) as it is in the method step A).Since the same cathode configuration can be used for the steps B) and C) there is no need to provide a separate cathode for the method step B) and this saves considerable cost, again making the process attractive commercially.

In the method at least the deposition step C) and optionally all method steps are carried out in an argon atmosphere in a vacuum treatment chamber at an argon pressure in the range from 1 to 10⁻³ millibar to 10⁻¹ millibar and preferably at 3 x 10⁻³ millibar.

This means the chamber atmosphere can be kept constant and no time is wasted changing the atmosphere in the chamber between different process steps. This again simplifies the process and reduces cost. The pre-treatment step A) is most preferably carried out using the method described in European patent EP 1 260 603

More specifically the method step A) is carried out using a HIPIMS power supply and any of the cathode configurations a), b) and c) and with a workpiece bias voltage higher than -500 volts and preferably of -1000 volts or greater.

In the preferred method the method steps B) and /or C) are carried out either with no separate bias voltage applied to the workpiece resulting in a floating bias potential of -30 to -40 volts or with a bias power supply connected to the workpiece and adapted to supply a bias voltage at the workpiece in the range from -30 volts to -200 volts.

When a bias power supply is used this is preferably designed in accordance with the European PCT application published as WO2007/115819.

The DC magnetron sputtering power supply connected to the graphite cathode or cathodes preferably results in an average power density at the cathode in the range from 1 to 3 Watts per square cm.

The HIPIMS power supply connected to the HIPIMS cathode or cathodes in the method steps B) and C) also results in an average power density in the range from 1 to 3 Watts per square cm and is operated with a duty cycle of pulse on time to pulse interval in the range from 0.5% to 4%.

As hinted at above the total area of the graphite cathodes is preferably in the range from 2 to 4 times that of the area of the HIPIMS cathode or cathodes, preferably three times as great.

An alternative method of making applying the coating of claim 1 to a workpiece using arc discharge rather than magnetron sputtering is set forth in claim 15.The invention will now be described in more detail by way of example only and with reference to Figs. 1 to 4 in which are shown:.
- Fig. 1: a schematic view of a cathode sputtering apparatus for depositing coatings in accordance with the present invention,
- Fig. 2: a horizontal cross-section through the vacuum chamber of the apparatus of Fig. 1 omitting some detail of Fig.1 but also showing additional details,
- Fig. 3: the typical profile of a high-intensity power supply as applied to the magnetron sputtering cathode of Fig. 1,
- Fig. 4: shows a plot of the voltage applied by the bias power supply to the substrate carrier and thus to any article or substrate mounted thereon.

In all drawings the same reference numerals have been used for the same components or features or for components having the same function and the description given for any particular component will not be repeated unnecessarily unless there is some distinction of importance. Thus a description given once for a particular component or feature will apply to any other component given the same reference numeral.

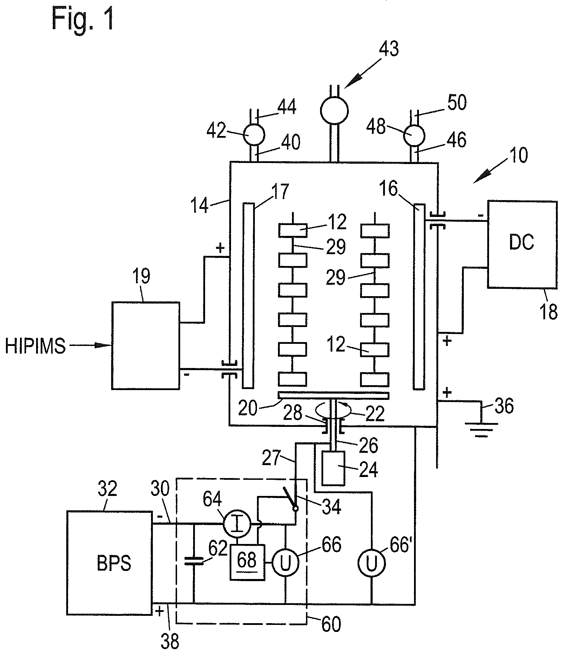

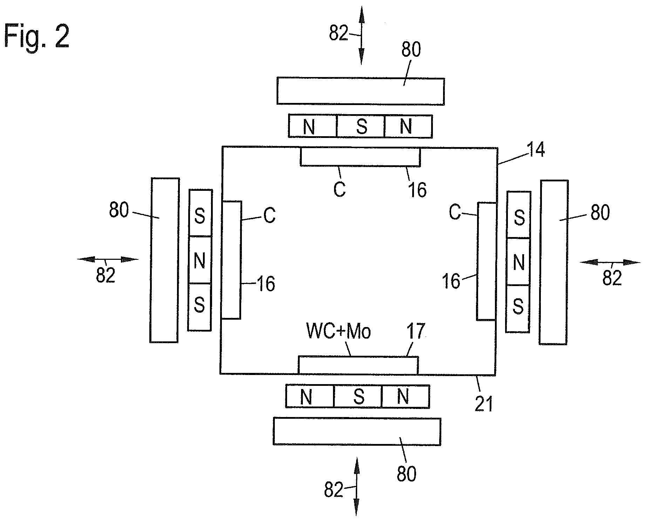

Referring first to Figs. 1 and 2 a vacuum coating apparatus 10 is shown for coating a plurality of substrates or workpieces 12. The apparatus includes a vacuum chamber 14 of metal, which in this example has three magnetron cathodes of graphite 16, which in this example are each connected to a common DC magnetron sputtering power supply 18, and a further magnetron cathode 17 of WC + Mo which is connected to a HIPIMS power supply 19. The term magnetron cathode will be understood to mean a cathode or target such as 16 or 17 having an associated magnetic system for generating a tunnel of magnetic field lines in the vacuum chamber in front of the respective cathode to ensure repeated collisions of electrons and the material of the cathodes for the purpose of generating ions of a material which is present in the gas phase in the chamber 14, i.e. inert gas ions and ions of the materials of which the respective cathodes are formed.

The workpieces 12 are mounted on a support device in the form of a table 20 which rotates in the direction of the arrow 22 by means of an electric motor 24. The electric motor drives a shaft 26 which is connected to the table 20. The shaft 26 passes through a lead-through 28 at the base of the chamber 14 in a sealed and isolated manner which is well known per se. This permits one terminal 30 of the bias power supply 32 to be connected via a lead 27 to the workpiece support 20 and thus to the workpieces. This substrate bias power supply 32 is shown here with the letters BPS, an abbreviation for bias power supply. The BPS is preferably equipped with HIPIMS-biasing capability, as described in the EP application 07724122.2 published as WO2007/115819, in particular, but not exclusively, with regard to the embodiment of Figs. 1 to 3.

In this example the metallic housing of the vacuum chamber 14 is connected to ground and this is at the same time the positive terminal of the apparatus. The positive terminals of the DC cathode power supply 18 and the high impulse cathode power supply 19 (HIPIMS power supply 19) are likewise connected to the housing 14 and thus to ground 36 as is the positive terminal of the bias power supply 32.

A connection stub 40 is provided at the top of the vacuum chamber 14 (but could be located at other locations as well) and can be connected via a valve 42 and a further line 44 to a vacuum system for the purpose of evacuating the treatment chamber 14. The vacuum system is not shown but well known in this field. A further line 50, which serves for the supply of an inert gas, especially argon, to the vacuum chamber 14, is likewise connected to the top of the vacuum chamber14 via a valve 48 and a further connection stub 46. If a transition layer of a nitride is desired then nitrogen can be supplied via an additional gas supply system 43.

The cathode 17 consisting of WC (tungsten carbide) and Mo (molybdenum) may, for example, be formed from powders of WC and Mo or may comprise a segmented cathode having segments of WC and segments of Mo, the relative amounts or areas of the two components WC and Mo are selected having regard to the respective sputtering yields so that, taking account of the additional hard carbon contributed by the three graphite cathodes the proportion of W and Mo in the coating to the proportion of C in atomic percent is typically in the range (W + Mo)/C is equal to 5 to 20 %, preferably 10 to 20 % and so that the ratio of W to Mo in the coating by atomic percent is in the range from 33 to 80 % especially from 50 to 75 % and especially of around 66%. The WC + Mo cathode 17 is connected to a HIPIMS cathode power supply 19.

Vacuum coating apparatus having a plurality of cathodes of different kinds are known in the prior art. For example a vacuum coating apparatus is available from the company IHI Hauzer Techno Coating BV in which the chamber has a generally square shape in cross-section with one cathode at each of the four sides as shown in a horizontal cross-section through the chamber in Fig.2. This design, which is admirably suited for carrying out the present process and depositing the coating in accordance with the present invention, has one side 21 designed as a door permitting access to the chamber 14. In another design the chamber is approximately octagonal in cross-section with two doors which each form three sides of the chamber. Each door can carry up to three magnetrons and associated cathodes 16, 17.

A typical vacuum coating apparatus includes a plurality of further devices which are not shown in the schematic drawings of this application. Such further devices comprise items such as dark space shields, heaters for the pre-heating of the substrates and sometimes electron beam sources or plasma sources in diverse designs.

When using the apparatus air is first extracted from the vacuum chamber 14 by the vacuum pumping system via the line 44, the valve 42 and the line 40 and the argon is supplied via the line 50, the valve48 and the connection stub 46. The chamber 14 and the workpieces 12 are preheated during pump-down to drive out any volatile gases or compounds which adhere to the workpieces or chamber walls.

The inert gas (argon) which is supplied to the chamber is always ionized to an initial extent, for example by cosmic radiation and splits up into ions and electrons.

In this example the HIPIMS cathode 17 is used for etching the workpieces which takes place in known manner in accordance with the EP patent

EP 1 260 603 by bombarding the workpieces with W, C, Mo and Ar ions while a high negative bias voltage is applied to the workpieces 12 of, for example, - 1200Volts. During this etching process the graphite cathodes 16 are switched off, i.e. not supplied with DC power by the power supply 18 which is itself switched off.

By generating a sufficiently high voltage on the workpieces, a glow discharge can be generated on the workpieces. The ions W, C, Mo and Ar are attracted to the workpieces and collide there with the material of the workpieces, thus etching the workpieces.

As soon as the etching treatment has been carried out the coating mode can be switched on. First of all it is convenient to deposit a transition layer of W, C and Mo on the etched surface of the workpiece. This can be done by HIPMS sputtering from the WC + Mo cathode 17 using a bias voltage which is significantly lower than that used for etching, for example in the range from -100 to -300 Volts, so that there is some implantation of the respective ions into the workpiece surface thereby forming a good transition or bond layer of, for example 100nm thickness. During the deposition of the transition layer the graphite cathodes 16 are still switched off.

Once the transition layer has been completed the actual coating of Me plus carbon can now be generated by simultaneous operation of the HIPIMS cathode 17 in the HIPIMS mode using the HIPIMS power supply and of the graphite cathodes using the DC power supply. The bias power supply BPS 32 then remains in operation to supply a negative bias to the substrates and to prevent arcing. It is a significant advantage of the present invention that the same bias power supply 32 copes both with DC magnetron sputtering from the graphite cathodes 16 and HIPIMS sputtering from the HIPIMS cathode 17 with no need for any form of adaptation to cope with the two sputtering modes and no need for any special synchronization of the bias voltage with the HIPIMS power pulses.

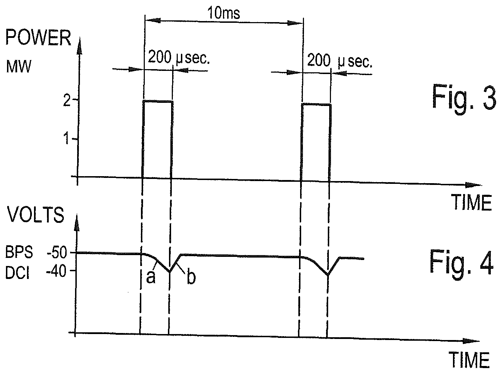

Moreover, the simultaneous use of HIPIMS with the magnetron cathode 17 and DC magnetron sputtering from the magnetron cathodes 16 has the significant advantage that the ionization in the chamber is kept high during the HIPIMS sputtering and this beneficially effects the sputtering from the graphite cathodes and leads to the desired ratio of the sp2 bonds to the sp3 bonds in the coating. The negative bias is generally maintained at a value in the range from -30 to -200 Volts although this value can drop off slightly during each HIPIMS pulse as will be explained with reference to Figs. 3 and 4. It is actually possible to dispense with a bias power supply and to allow the workpieces 12 to reach a floating potential which is ordinarily between about - 30Volts to - 40Volts. However, some form of arcing protection circuitry would normally be necessary. Naturally, the provision of the bias power supply 32 allows much improved control of the process.

The power supply to the cathode or cathodes causes a flux of ions of the material of the cathode to move into the space occupied by the workpieces 12 and to coat them with the material of the respective cathode. The structure of the coating is influenced by the applied negative bias voltage that influences the movement of ions towards the workpieces.

In a HIPIMS mode the power which is supplied to the cathode 17 during a power impulse can be much higher than the power of a DC sputtering mode because there are substantial intervals between each pulse. However, the average power remains the same as for DC puttering. The limiting constraint on the power is the amount of heat that can be dissipated at the cathode before this overheats. Accordingly, HIPIMS cathodes of about 1200square cm's surface area (rectangular cathodes of 60cm's x 20 cm' are frequently used) are generally not operated at average powers above about 20 kW. The DC magnetron sputtering power supply would normally also provide a power in the range from 15kW to 20kW. In the case of a graphite target or cathode 16 of the same size the amount of power which can be dissipated by each cathode is about 5 to 6 kW which is why three graphite cathodes 16 are typically used with one DC power supply.

In a typical HIPIMS sputtering process (high power impulse magnetron sputtering), each power pulse can have a duration of say 200 µs the apparatus is operated with a duty cycle of 0.5 to 4 % particularly of 1 to 2 %, i.e. the ratio of the pulse on time to the pulse off time. These values are only given as an example and can be varied in wide limits. As the time during which a very high peak power is applied to the cathodes is short, the average power can be kept to a moderate level equivalent to that of a DC sputtering process. It has however been found that by the application of high power impulses at the cathode these operate in a different mode in which a very high degree of ionization of the ions arises which are ejected from the cathodes, with this degree of ionization, which is material dependent, lying in the range between 20% and indeed up to 90%. As a result of this high degree of ionization, many more ions are attracted by the workpieces and arrive there with higher velocities which lead to denser coatings and make it possible to achieve higher coating rates and better coating properties than regular DC magnetron sputtering. In the present case the metal ions in the vacuum chamber are found to be ionized to values between 20% and 90% and it is preferred when the ionization values are above 50%.

The fact that the power is supplied in power peaks (pulses) means however that relatively high currents flow in the bias power supply during these power peaks and the current take up cannot be readily supplied by a normal power supply.

In order to overcome this difficulty WO 2007/115819 describes a solution as shown in Fig. 1 of this application in which an additional voltage source 60 is provided which is best realized by a capacitor. The capacitor 62 is charged by a customary bias power supply to the desired output voltage. When a power impulse arrives at one of the cathodes from the HIPIMS power supply 18 then this leads to an increased material flow of ions, essentially ions of the cathode material to the workpieces 12 and this signifies an increase of the bias current at the bias power supply (BPS) via the workpiece support 20 and the line 27. A normal bias power supply could not deliver such a peak current when it is designed for constant DC operation instead of HIPIMS operation. However, the capacitor 62, which is charged by the bias power supply to the desired voltage in the periods between the power impulses, is able to keep the desired bias voltage at the substrates constant within narrow limits and to supply the required current which only causes a small degree of discharging of the capacitor. In this way, the bias voltage remains at least substantially constant.

During the intervals between the high power pulses from the cathode power supply 19 the DC sputtering from the graphite cathodes 16 is still taking place but the bias current that is flowing is relatively low.. The BPS 32 is able to maintain the bias voltage at the substrate carrier 20 within close limits and to support the relatively low flow of current when only the graphite cathodes are operating, during the pauses between sequential HIPIMS power pulses at the cathode 17 and it is also able to support the relatively high flow of current which results when the HIPIMS power supply is applying power to the HIPIMS cathode 17 in addition to the DC power being supplied to the graphite cathodes. However, the increase in current during the HIPIMS power pulses only results in slight discharging of the capacitor, as shown in the drawing of Fig. 4, where it can be seen that the charged voltage across the capacitor, shown in this example as being -50 V, has reduced to say - 40 V within the 200µs duration of the high power pulse from the cathode power supply 19 to the cathode 17 (see section "a" of the curve of Fig. 4). Once this pulse ceases, the capacitor again charges up to the -50 V level and has reached this level shortly after the termination of the high power pulse (see section "b" of the curve of Fig. 3. This voltage level is maintained during the operation of the graphite cathodes in the DC sputtering mode until another power impulse arises from the power supply 18 to the cathode 17 and then drops again to -40 V over the duration of the high power pulse before recharging starts again.

It should be noted that similar (undesired but tolerable) voltage drops will occur while the system is etching, i.e. bias voltages are at much higher levels, say between less than 700 V up to 1200 V and higher. It will be appreciated that the capacitor provides only a low impedance to the current flowing so that the current flowing is short-circuited through the capacitor rather than flowing through the higher impedance of the bias power supply. It should be appreciated that although the peak flow of ions to the substrates occurs during the power peak applied by the cathode power supply to the cathode this does not mean that the flow ceases as soon as the power peak is over. Instead it is entirely possible that the flux of ions continues, albeit at a reduced level with reduced current, during the intervals between successive power peaks, where the applied power on the cathodes is much lower.

Naturally, it is also possible for arcing to take place in the treatment chamber with the system just described. In this case, the arcing further modifies various operating parameters of the system, for example the current flowing in the line 27 and the voltage across the capacitor 62. Thus, detectors can be provided, such as 64, which detect the current flowing in the line 32, and 66, which detects the voltage across the capacitor and the output signals from these detectors can be fed to an arcing suppression circuit 68 which is connected to operate a semiconductor switch shown schematically at 34 in Fig. 1. Thus, if the arcing detection circuit detects values of current and/or voltage which indicate the presence of arcing at the articles 12 or at the substrate carrier 20, then the arcing suppression circuit operates to open the switch 34, thus interrupting the bias voltage present at the substrate carrier 20 and at the substrates 12 and leading to prompt extinguishing of the arc. The broken line including the detector 66' shows an alternative position for the voltage detector 66, i.e. directly between the line 27 and the positive terminal of the bias power supply 32, i.e. on the other side of the switch 34 from the detector 66. The position shown for the detector 66' is the preferred position.

In this embodiment the arc suppression circuit is included in the voltage source 60, it could however be a module separate from the voltage source 60 or incorporated into the bias power supply 32.

Returning now to Fig. 2 some further information will be given on the preferred layout. It will be seen that the two oppositely disposed cathodes 16 at the sides of Fig. 2 have magnet arrangements with centre poles of polarity "north" (N) and outside poles of polarity "south" (S) to generate the well-known magnetic tunnel of a magnetron. The cathodes have the shape of elongate rectangles when viewed face on and are shown here in a cross-section perpendicular to their long axis. Instead of having SNS polarity as shown, they could have NSN polarity as shown for the magnet arrangements for the cathodes 16 and 17 at the top and bottom of Fig. 2. The two cathodes 16 and 17 at the top and bottom of Fig. 2 would then have magnet arrangements with SNS polarity.

The magnet arrangements can be moved in the direction of the respective double arrows 82 towards and away from the respective cathodes 16. This is an important control parameter for the operation of the HIPIMS cathodes.

The idea is for the magnetrons to have alternating polarities going around the vacuum chamber 14. This means, with an even number of cathodes that the magnetic poles always alternate, i.e. N, S, N, S, N, S, N, S, N, S, N, S, when going around the chamber. This leads to an enhanced magnetic confinement of the plasma. A similar magnetic confinement can also be achieved if all cathodes have the same polarities, say NSN. Then it is necessary to operate with auxiliary S poles between the adjacent magnetrons to obtain a similar N, S, N, S, N arrangement around the chamber. It will be appreciated that the described arrangements only work with an even number of magnetrons. However, it is also possible to obtain a similar effect with an odd number of magnetrons either by making some poles stronger than others or by the use of auxiliary poles. Such designs to obtain a closed plasma are well known and documented in various patent applications. Generally so-called imbalanced magnetrons are preferred.

What Fig. 2 also shows is four rectangular coils 80 positioned like the magnets with the SNS poles or NSN poles outside of the chamber 14. The coils form electromagnets and have the same polarity as the outer magnets for the respective cathodes 16, 17. These electromagnetic coils 80 enable the magnetic flux in front of the cathodes 16 and inside the chamber 14, to be varied.

The description given above explains how the coating in accordance with the invention can be made by magnetron sputtering. It is, however, also possible to make the coating of the invention using arc technology.

More specifically, besides using HIPIMS/Magnetron combinations, the coatings can be produced by combining carbon, evaporated from arc sources, with Mo and W evaporated by magnetron sputtering from separate Mo or WC (or simply W) targets. However, WC targets are preferred. This is less costly, as pure W targets are much more expensive, since they are not readily available in the market.

As an alternative the Mo and W can be sputtered form one WC target in which Mo plugs are mounted. This is incidentally a form of target segmentation as referred to above.

In yet another alternative one can also use Mo-targets, in which W and/or WC-plugs are mounted.

As an example for the use of arc technology for manufacturing the coatings the following process parameters are important for a method using metal doped ta-C coatings (ta-C coatings are a type of DLC coating):
When a number of graphite targets is used with an arc discharge to evaporate the graphite, a ta-C coating is made. Normally the arc cathodes are round and are, for example, of 63mm diameter and are arranged in a straight vertical line. The coating can be doped by activating one sputter target with Mo and one sputter target with WC, running at low power levels. The target dimensions for the magnetron sputter targets in a F1200 system available from the present applicants are: height 100 cm, width 17 cm. By controlling the levels of power the concentration of the Mo and W in the ta-C coating can individually be controlled.

Such processes are already known per se for doping of pure WC, additional doping with Mo is therefore possible under the conditions as described. By the addition of H₂ and/or C₂H₂, the coating will be made softer and will change into ta-C:H:W:Mo. It will be understood that the composition of the coating can also be ta-C:W:Mo, i.e. the addition of hydrogen to the coating is not essential. The magnetron sputtering from the Mo and/or WC cathodes can be carried out as before using HIPIMS but can alternatively be carried out by using DC Magnetron sputtering. If the WC target is run with a power of 200 W in a F1200 machine (power density: 110 mW/cm²; i.e. 200 W/m if the power is related to the height of the cathode), and if a bank of 5 arc cathodes of 63mm diameter is run with a current of 60 - 80 A (which means a current density of 240-320 A/m) one obtains a coating with a deposition rate of 0,01 µm/h WC and 1µm/h ta-C. The atomic percentage contents of metal in case of pure W-doping was 1%, but merely by recalculating the metal-doping percentage of W and assuming that Mo has a similar deposition rate as W, we estimated the doping concentration (no SIMS measurements have been made yet to confirm the atomic percentages).

The doping level is in this case therefore approximately 1%. By combining this with a sputter cathode for Mo we can add 1% Mo under the same conditions (to a rough estimation)

If we increase the power on the W cathode and on the Mo cathode, we can increase the amount of metal from 2% to 25% by increasing the power on each of the sputter cathodes to a level of 1250 W.

Thus by varying the sputtering power applied to the Mo and/or WC cathode(s) it is possible to apply an arc coating for getting a W/Mo-doped carbon coating with less than 20 to 25% metal content.

In addition to the above described generation of the metallic component by magnetron sputtering it is also conceivable to generate the metal component in the coating by arc sputtering from the metal or metal containing cathode(s) although this makes it more difficult to achieve the desired proportion of metal of up to 20%.

It is also possible to generate the Me-doped C-coatings by arc sputtering or HIPIMS sputtering or DC magnetron sputtering from a single graphite cathode or target having inserts or plugs of the respective metal such as Mo and/or W and/or of WC. In this case the respective free surface areas of the plugs or inserts and the of the graphite body are selected having regard to the respective sputtering yields to deliver the desired composition of the Me-doped C-coating and, if required the desired ratio of the Mo and W components in the Me-doped C-coating.

When arc sputtering is used the pressure prevailing in the treatment chamber are typically the same as quoted above for magnetron sputtering.

If a nitride coating is required this can be achieved by admitting nitrogen to the treatment chamber.

## Claims

1. A workpiece having a metal doped carbon coating wherein the Me-doped C coating is for operation in boundary lubrication conditions, in which the metal is present in the coating in an amount of from 5 to 20% by atomic percent and the ratio of the atomic percentage of the metal Me to the atomic percentage of the carbon C does not exceed 1:4, the metal being capable of forming a metal sulphide with sulphur present in a lubricant and being a mixture of W and Mo in a ratio in the range by atomic percent of W:Mo from 0.5:1 to 4:1.

2. A workpiece having a metal doped carbon coating in accordance with claim 1, wherein the ratio of W to Mo in the mixture is in the range of 1:1 to 3:1 by atomic percent.

3. A workpiece having a metal doped carbon coating in accordance with claim 1, wherein the ratio of W to Mo in the mixture is 2:1 by atomic percent.

4. A workpiece having a metal doped carbon coating in accordance with any one of the preceding claims in which the ratio of sp2 carbon bonds to sp3 carbon bonds is in the range from sp2/sp3 equal to 20 to 50% preferably 30-35%.

5. Use of a metal doped carbon coating in accordance with any one of the preceding claims with an oil containing sulphur in the form of a refined oil or a refined oil containing additives.

6. Use of a metal doped carbon coating in accordance with any one of the preceding claims at a temperature in the range from 0°C-500°C.

7. A workpiece having a metal doped carbon coating in accordance with any one of the preceding claims having a thickness in the range from 500 nm to 10 µm.

8. A workpiece having a doped carbon coating in accordance with any one of the preceding claims having the composition ta-C:Mo:W or ta-C:H:W:Mo.

9. A method of depositing a metal doped carbon coating in accordance with claim 1 on a workpiece comprising the following method steps:
A) pre-treating a workpiece surface by simultaneous bombardment of the surface with accelerated ions of at least one of W and C ions, Mo and C ions and W, Mo and C ions generated by a HIPIMS discharge in a treatment chamber,
B) deposition of a transition layer of metal and/or metal nitride of a thickness in the range from 20nm-1000nm thick by magnetron sputtering, the metal being at least one of W and Mo,
C) deposition of a main layer comprising the Me- doped C coating by magnetron sputtering using one of the following cathode configurations:
a) a HIPIMS sputtering cathode comprising W, Mo and C and being either a cathode made from the respective components W, Mo and C, or of WC and Mo made by a powder metallurgical sintering route, or by casting or by mechanical segmentation and an associated HIPIMS power supply,
b) a HIPIMS sputtering cathode comprising Wand Mo, and an associated HIPIMS power supply,
c) a first HIPIMS sputtering cathode comprising one of W and WC and a second HIPIMS sputtering cathode comprising Mo, each cathode having an associated HIPIMS power supply, which may be a common power supply,
d) any one of the foregoing cathode configurations a), b) and c) in combination with one or more graphite cathodes each with an associated DC sputtering power supply, which may be a common power supply.

10. A method in accordance with claim 9 wherein at least the deposition step C) and optionally all transition steps, such as steps A) and B) are carried out in an argon atmosphere in a vacuum treatment chamber at an argon pressure in the range from 1 to 10⁻³ millibar to 10⁻¹ millibar.

11. A method in accordance with claim 9 or claim 10 wherein the pre-treatment step A) is carried out using a HIPIMS power supply and any of the cathode configurations a), b) and c) and with a workpiece bias voltage higher than - 500 volts and/or wherein the method steps B) and /or C) are carried out either with no separate bias voltage applied to the workpiece resulting in a floating bias potential of -30 to -40 volts or with a bias power supply connected to the workpiece and adapted to supply a bias voltage at the workpiece in the range from -30 volts to -200 volts.

12. A method in accordance with any one of the preceding claims 9 to 11 wherein the magnetron sputtering used in step C) comprises DC magnetron sputtering using a DC magnetron sputtering power supply connected to the graphite cathode or cathodes results in an average power density at the cathode in the range from 1 to 3 Watts per square cm.

13. A method in accordance with any one of the preceding claims 9 to 11 wherein the magnetron sputtering used in step C) is carried out with a HIPIMS power supply connected to the HIPIMS cathode or cathodes and results in an average power density in the range from 1 to 3 Watts per square cm and is operated with a duty cycle of pulse on time to pulse interval in the range from 0.5% to 4%.

14. A method in accordance with any one of the preceding claims 9 to 13 wherein the total area of the graphite cathodes is in the range from 2 to 4 times as great as the area of the HIPIMS cathode or cathodes, preferably three times as great.

15. A method of depositing a metal doped carbon coating in accordance with claim 1 on a workpiece comprising the following method steps:
A) pre-treating a workpiece surface by simultaneous bombardment of the surface with accelerated ions of at least one of W and C ions, Mo and C ions and W, Mo and C ions, the ions being either generated by a HIPIMS discharge in a treatment chamber, or by a DC magnetron discharge in a treatment chamber, or by an arc discharge in a treatment chamber,
B) deposition of a transition layer of metal and/or metal nitride of a thickness in the range from 20nm-1000nm thick by magnetron sputtering or by an arc discharge, the metal being at least one of Wand Mo,
C) deposition of a main layer comprising an Me- doped C coating by an arc discharge from at least one graphite cathode wherein, in addition to the at least one graphite cathode Mo, W and optionally also C atoms are generated from one of the following cathode configurations:
a) a cathode comprising W, Mo and C and being either a cathode made from the respective components W, Mo and C, or of WC and Mo made by a powder metallurgical sintering route, or by casting or by mechanical segmentation,
b) a cathode comprising W and Mo,
c) a first cathode comprising one of W and WC and a second cathode comprising Mo.

## Patentansprüche

1. Werkstück mit einer metalldotierten Kohlenstoffbeschichtung, wobei die Me-dotierte C-Beschichtung zum Betrieb unter Grenzschmierbedingungen vorgesehen ist, in welcher das Metall in der Beschichtung in einer Menge von 5 bis 20 Atom-% vorhanden ist und das Verhältnis des atomaren Prozentsatzes des Metalls Me zu dem atomaren Prozentsatz des Kohlenstoffes C 1:4 nicht überschreitet, wobei das Metall in der Lage ist, mit Schwefel, das in einem Schmiermittel vorhanden ist, ein Metallsulfid zu bilden und ein Gemisch aus W und Mo in einem Verhältnis in einem Atomprozentbereich von W:Mo von 0,5:1 bis 4:1 ist.

2. Werkstück mit einer metalldotierten Kohlenstoffbeschichtung nach Anspruch 1, wobei das Verhältnis W zu Mo in dem Gemisch in einem Atomprozentbereich von 1:1 bis 3:1 liegt.

3. Werkstück mit einer metalldotierten Kohlenstoffbeschichtung nach Anspruch 1, wobei das Atomprozentverhältnis von W zu Mo in dem Gemisch 2:1 beträgt.

4. Werkstück mit einer metalldotierten Kohlenstoffbeschichtung nach einem der vorhergehenden Ansprüche, bei welchem das Verhältnis von sp2-Kohlenstoffbindungen zu sp3-Kohlenstoffbindungen im Bereich von sp2/sp3 gleich 20 bis 50%, vorzugsweise 30-35% liegt.

5. Verwendung einer metalldotierten Kohlenstoffbeschichtung nach einem der vorhergehenden Ansprüche mit einem Schwefel enthaltenden Öl in der Form eines raffinierten Öls oder eines raffinierten Öls, das Additive enthält.

6. Verwendung einer metalldotierten Kohlenstoffbeschichtung nach einem der vorhergehenden Ansprüche bei einer Temperatur im Bereich von 0°C bis 500°C.

7. Werkstück mit einer metalldotierten Kohlenstoffbeschichtung nach einem der vorhergehenden Ansprüche mit einer Dicke im Bereich von 500 nm bis 10 µm.

8. Werkstück mit einer dotierten Kohlenstoffbeschichtung nach einem der vorhergehenden Ansprüche, das die Zusammensetzung ta-C:Mo:W oder ta-C:H:W:Mo aufweist.

9. Verfahren zum Abscheiden einer metalldotierten Kohlenstoffbeschichtung nach Anspruch 1 auf ein Werkstück mit den folgenden Verfahrensschritten:
A) Vorbehandeln einer Werkstückoberfläche durch gleichzeitige Bombardierung der Oberfläche mit beschleunigten Ionen von zumindest einem von W- und C-Ionen, Mo- und C-Ionen und W-, Mo- und C-Ionen, die durch eine HIPIMS-Entladung in einer Behandlungskammer erzeugt werden,
B) Abscheiden einer Übergangsschicht aus Metall und/oder Metallnitrid mit einer Dicke im Bereich von 20 nm bis 1000 nm Dicke durch Magnetronsputtern, wobei das Metall zumindest eines von W und Mo ist,
C) Abscheiden einer Hauptschicht, die die Me-dotierte C-Beschichtung umfasst, durch Magnetronsputtern unter Verwendung der folgenden Kathodenkonfigurationen:
a) eine HIPIMS-Sputterkathode, die W, Mo und C umfasst und eine Kathode ist, die aus den jeweiligen Komponenten W, Mo und C oder aus WC und Mo hergestellt ist, die durch einen pulvermetallurgischen Sinterweg oder durch Gießen oder durch mechanische Segmentierung hergestellt ist, und eine zugehörige HIPIMS-Stromversorgung umfasst,
b) eine HIPIMS-Sputterkathode, die W und Mo und eine zugehörige HIPIMS-Stromversorgung umfasst,
c) eine erste HIPIMS-Sputterkathode, die eines von W und WC umfasst, und eine zweite HIPIMS-Sputterkathode, die Mo umfasst, wobei jede Kathode eine zugehörige HIPIMS-Stromversorgung aufweist, welche eine gemeinsame Stromversorgung sein kann,
d) irgendeine der vorstehenden Kathodenkonfigurationen a), b) und c) in Kombination mit einer oder mehreren Graphitkathoden, jeweils mit einer zugehörigen DC-Sputterstromversorgung, die eine gemeinsame Stromversorgung sein kann.

10. Verfahren nach Anspruch 9, wobei zumindest der Abscheidungsschritt C) und optional alle Übergangsschritte, wie etwa Schritte A) und B), in einer Argonatmosphäre in einer Vakuumbehandlungskammer bei einem Argondruck im Bereich von 1 bis 10⁻³ Millibar bis 10⁻¹ Millibar aufgeführt werden.

11. Verfahren nach Anspruch 9 oder Anspruch 10, wobei der Vorbehandlungsschritt A) unter Verwendung einer HIPIMS-Stromversorgung und irgendeiner der Kathodenkonfigurationen a), b) und c) und mit einer Werkstückvorspannung höher als -500 Volt ausgeführt wird, und/oder wobei die Verfahrensschritte B) und/oder C) entweder ohne separate Vorspannung, die an das Werkstück angelegt wird, was zu einem schwimmenden Vorspannungspotential von -30 bis -40 Volt führt, oder mit einer Vorspannungsstromversorgung, die mit dem Werkstück verbunden ist und ausgebildet ist, um an das Werkstück eine Vorspannung im Bereich von -30 Volt bis -200 Volt anzulegen, ausgeführt wird.

12. Verfahren nach einem der vorhergehenden Ansprüche 9 bis 11, wobei das in Schritt C) verwendete Magnetronsputtern DC-Magnetronsputtern unter Verwendung einer DC-Magnetronsputterstromversorgung, die mit der Graphitkathode oder den Graphitkathoden verbunden ist, umfasst, was zu einer durchschnittlichen Leistungsdichte an der Kathode im Bereich von 1 bis 3 Watt pro Quadratzentimeter führt.

13. Verfahren nach einem der vorhergehenden Ansprüche 9 bis 11, wobei das in Schritt C) verwendete Magnetronsputtern mit einer HIPIMS-Stromversorgung, die mit der HIPIMS-Kathode oder den HIPIMS-Kathoden verbunden ist, ausgeführt wird und zu einer durchschnittlichen Leistungsdichte im Bereich von 1 bis 3 Watt pro Quadratzentimeter führt und mit einem Tastverhältnis von Einschaltpulszeit zu Pulsintervall im Bereich von 0,5% bis 4% betrieben wird.

14. Verfahren nach einem der vorhergehenden Ansprüche 9 bis 13, wobei die Gesamtfläche der Graphitkathoden im Bereich von 2 bis 4 Mal so groß wie die Fläche der HIPIMS-Kathode oder HIPIMS-Kathoden, vorzugsweise drei Mal so groß ist.

15. Verfahren zum Abscheiden einer metalldotierten Kohlenstoffbeschichtung nach Anspruch 1 auf ein Werkstück mit den folgenden Verfahrensschritten:
A) Vorbehandeln einer Werkstückoberfläche durch gleichzeitiges Bombardement der Oberfläche mit beschleunigten Ionen von zumindest einem von W- und C-Ionen, Mo- und C-Ionen und W-, Mo- und C-Ionen, wobei die Ionen erzeugt werden durch eine HIPIMS-Entladung in einer Behandlungskammer oder durch eine DC-Magnetronentladung in einer Behandlungskammer oder durch eine Bogenentladung in einer Behandlungskammer,
B) Abscheiden einer Übergangsschicht aus Metall und/oder Metallnitrid mit einer Dicke im Bereich von 20 nm bis 1000 nm Dicke durch Magnetronsputtern oder durch eine Bogenentladung, wobei das Metall zumindest eines von W und Mo ist,
C) Abscheiden einer Hauptschicht, die eine Me-dotierte C-Beschichtung umfasst, durch eine Bogenentladung von zumindest einer Graphitkathode, wobei zusätzlich zu der zumindest eine Graphitkathode Mo-, W- und optional auch C-Atome aus einer der folgenden Kathodenkonfigurationen erzeugt werden:
a) eine Kathode, die W, Mo und C umfasst und eine Kathode ist, die aus den jeweiligen Komponenten W, Mo und C oder aus WC und Mo hergestellt ist, die durch einen pulvermetallurgischen Sinterweg oder durch Gießen oder durch mechanische Segmentierung hergestellt ist,
b) eine Kathode, die W und Mo umfasst,
c) eine erste Kathode, die eines von W und WC umfasst, und eine zweite Kathode, die Mo umfasst.

## Revendications

1. Pièce à oeuvrer ayant un revêtement de carbone dopé de métal dans laquelle le revêtement de C à dopage Me est destiné à fonctionner dans des conditions de lubrification frontières, dans laquelle le métal est présent dans le revêtement dans une quantité de 5 à 20 atomes % et le rapport du pourcentage atomique du métal Me sur le pourcentage atomique du carbone C n'excède pas 1:4, le métal étant capable de former un sulfure de métal avec du soufre présent dans un lubrifiant et étant un mélange de W et de Mo dans un rapport de pourcentage atomique de W:Mo dans la plage de 0,5:1 à 4:1.

2. Pièce à oeuvrer ayant un revêtement de carbone dopé de métal selon la revendication 1, dans laquelle le rapport de W sur Mo dans le mélange est dans la plage de 1:1 à 3:1 atomes %.

3. Pièce à oeuvrer ayant un revêtement de carbone dopé de métal selon la revendication 1, dans laquelle le rapport de W sur Mo dans le mélange est de 2:1 atomes %.

4. Pièce à oeuvrer ayant un revêtement de carbone dopé de métal selon l'une quelconque des revendications précédentes, dans laquelle le rapport sp2/sp3 des liaisons carbone sp2 sur les liaisons carbone sp3 est dans la plage de 20 à 50 %, de préférence de 30 à 35 %.

5. Utilisation d'un revêtement de carbone dopé de métal selon l'une quelconque des revendications précédentes, avec une huile contenant du soufre sous la forme d'une huile raffinée ou d'une huile raffinée contenant des additifs.

6. Utilisation d'un revêtement de carbone dopé de métal selon l'une quelconque des revendications précédentes à une température dans la plage de 0° C à 500° C.

7. Pièce à oeuvrer ayant un revêtement de carbone dopé de métal selon l'une quelconque des revendications précédentes, ayant une épaisseur dans la plage de 500 nm à 10 µm.

8. Pièce à oeuvrer ayant un revêtement de carbone dopé de métal selon l'une quelconque des revendications précédentes ayant pour composition ta-C:Mo:W ou ta-C:H:W:Mo.

9. Procédé de déposition d'un revêtement de carbone dopé de métal selon la revendication 1 sur une pièce à oeuvrer, comprenant les étapes suivantes consistant à :
A) préchauffer une surface d'une pièce à oeuvrer par bombardement simultané de la surface avec des ions accélérés de l'un au moins parmi des ions W et C, des ions No et C, et des ions W, Mo et C générés par une décharge de type HIPIMS dans une chambre de traitement,
B) déposition d'une couche de transition de métal et/ou de nitrure de métal d'une épaisseur dans la plage de 20 nm à 1000 nm d'épaisseur par pulvérisation au magnétron, le métal étant au moins un parmi W et Mo,
C) déposition d'une couche principale comprenant le revêtement de C dopé de Me par pulvérisation au magnétron utilisant l'une des configurations de cathode suivantes :
a) une cathode de pulvérisation du type HIPIMS comprenant W, Mo et C et étant soit une cathode faite à partir des composants respectifs W, Mo et C, soit des composants WC et Mo réalisée par une procédure de frittage en métallurgie des poudres, soit encore par coulée ou par segmentation mécanique et avec une alimentation de puissance HIPIMS associée,
b) une cathode de pulvérisation du type HIPIMS comprenant W et Mo, et une alimentation de puissance HIPIMS associée,
c) une première cathode de pulvérisation du type HIPIMS comprenant un composant parmi W et WC et une seconde cathode pulvérisation du type HIPIMS comprenant du Mo, chaque cathode ayant une alimentation de puissance HIPIMS associée, qui peut être une alimentation de puissance commune,
d) l'une quelconque des configurations de cathode suivantes a), b) et c) en combinaison avec une ou plusieurs cathodes en graphite, chacune avec une alimentation de puissance de pulvérisation associée en courant continu, qui peut être une alimentation de puissance commune.

10. Procédé selon la revendication 9, dans lequel au moins l'étape de déposition C) et en option toutes les étapes de transition, comme les étapes A) et B), sont effectuées dans une atmosphère d'argon dans une chambre de traitement sous vide avec une pression d'argon dans la plage de 1 à 10⁻³ mbar à 10⁻¹ mbar.

11. Procédé selon la revendication 9 ou 10, dans lequel l'étape de prétraitement A) est effectuée en utilisant une alimentation de puissance HIPIMS et l'une quelconque des configurations de cathode a), b) et c), et avec un voltage de polarisation de la pièce à oeuvrer plus élevé que -500 V, et/ou dans lequel les étapes B) et/ou C) du procédé sont effectuées soit sans application séparée d'un voltage de polarisation à la pièce à oeuvrer avec pour résultat un potentiel de polarisation flottant de -30 à -40 V, soit avec une alimentation de puissance de polarisation connectée à la pièce à oeuvrer et adaptée à alimenter un voltage de polarisation à la pièce à oeuvrer dans la plage de -30 volts à -200 V.

12. Procédé selon l'une quelconque des revendications 9 à 11, dans lequel la pulvérisation à magnétron utilisée dans l'étape C) comprend une pulvérisation à magnétron en courant continu utilisant une alimentation de puissance de pulvérisation de magnétron à courant continu connectée à la cathode ou aux cathodes en graphite avec pour résultat une densité de puissance moyenne au niveau de la cathode dans la plage de 1 à 3 watts par centimètre carré.

13. Procédé selon l'une quelconque des revendications précédentes 9 à 11, dans lequel la pulvérisation à magnétron utilisée dans l'étape C) est effectuée avec une alimentation de puissance HIPIMS connectée à la cathode ou aux cathodes HIPIMS et a pour résultat une densité de puissance moyenne dans la plage de 1 à 3 W par centimètre carré, et est amenée à fonctionner avec un cycle de service concernant la temporisation sur l'intervalle des impulsions dans la plage de 0,5 % à 4 %.

14. Procédé selon l'une quelconque des revendications précédentes 9 à 13, dans lequel l'aire totale des cathodes en graphite est dans la plage de 2 à 4 fois plus élevée que l'aire de la cathode ou des cathodes HIPIMS, de préférence trois fois plus élevée.

15. Procédé pour déposer un revêtement de carbone dopé de métal selon la revendication 1 sur une pièce à oeuvrer, comprenant les étapes suivantes consistant à :
A) prétraiter une surface d'une pièce à oeuvrer par bombardement simultané de la surface avec des ions accélérés de l'un au moins des ions W et C, des ions Mo et C, et des ions W, Mo et C, les ions étant générés soit par une décharge de type HIPIMS dans une chambre de traitement, soit par une décharge à magnétron en courant continu dans une chambre de traitement, soit encore par une décharge d'un arc dans une chambre de traitement,
B) déposer une couche de transition de métal et/ou d'un nitrure de métal d'une épaisseur dans la plage de 20 nanomètres à 1000 nm d'épaisseur par pulvérisation par magnétron ou par la décharge d'un arc, le métal étant un au moins parmi W et Mo,
C) déposer une couche principale comprenant un revêtement de C dopé de Me par décharge d'un arc depuis au moins une cathode en graphite, dans lequel, en plus de ladite cathode en graphite, des atomes de Mo, W, et en option également de C sont générés à partir de l'une des configurations de cathode suivantes :
a) une cathode comprenant W, Mo et C, qui est soit une cathode faite à partir des composants respectifs W, Mo et C, soit à partir des composants WC et Mo, réalisée par une procédure de frittage en métallurgie des poudres, soit encore par coulée ou par segmentation mécanique,
b) une cathode comprenant W et Mo,
c) une première cathode comprenant un composant parmi W et WC, et une seconde cathode comprenant Mo.
